# FASCICULE DE BREVET EUROPEEN

(11) **EP 3 099 150 B1**
(45) Date de publication et mention de la délivrance du brevet: **26.09.2018**
(21) Numéro de dépôt: 16170968.8
(22) Date de dépôt: 24.05.2016
(51) Int. Cl.: H05K 7/14

(54) **EQUIPEMENT ELECTRONIQUE COMPORTANT UN BOITIER ET AU MOINS UNE CARTE ELECTRONIQUE PROTEGEE CONTRE LA FOUDRE**
ELEKTRONISCHE AUSRÜSTUNG, DIE EIN GEHÄUSE UND MINDESTENS EINE ELEKTRONISCHE KARTE MIT BLITZSCHUTZ UMFASST
ELECTRONIC DEVICE COMPRISING A HOUSING AND AT LEAST ONE ELECTRONIC CARD PROTECTED AGAINST LIGHTNING

(30) Priorité: 29.05.2015 FR 1554879
(43) Date de publication de la demande: 30.11.2016
(73) Titulaire: Airbus Operations (S.A.S.), 31060 Toulouse Cedex 9 (FR)
(72) Inventeur: ENGELVIN, Pierre-Louis, 31450 ODARS (FR); LAFONT, Patrice, 31280 MONS (FR)
(74) Mandataire: Cabinet Le Guen Maillet

(56) Documents cités:
- EP-A1- 0 824 302
- FR-A1- 2 927 222

## Description

### DOMAINE TECHNIQUE

La présente invention concerne un équipement électronique comportant un boîtier et au moins une carte électronique protégée contre la foudre, ainsi qu'un aéronef comportant un tel équipement électronique.

### ETAT DE LA TECHNIQUE ANTERIEURE

Le document FR-A-2 927 222 et le document EP-A-0 824 302 divulguent des équipements électroniques comportant un boîtier et au moins une carte électronique à protéger contre la foudre.

Un aéronef comprend de nombreux équipements électroniques. Un certain nombre d'équipements électroniques comportent un boîtier dans lequel sont disposées une carte fond de panier ("backplane" en terminologie anglo-saxonne) et une pluralité de cartes électroniques, dites cartes filles. Chaque carte fille est fixée sur la carte fond de panier à l'aide d'un port approprié. L'équipement électronique présente également un connecteur qui est électriquement connecté à la carte fond de panier et qui permet de connecter électriquement la carte fond de panier au reste du système électronique de l'aéronef.

Pour protéger les composants présents dans l'équipement électronique, celui-ci comporte également une carte de protection anti-foudre. Cette carte de protection anti-foudre se présente sous la forme d'un circuit imprimé sur lequel sont fixés des composants électroniques prévus pour servir de fusible et empêcher le passage des courants électriques générés par la foudre vers les cartes filles.

Actuellement, différents agencements sont prévus, et si ces différents agencements sont satisfaisants du point de vue de la sécurité, ils ne le sont pas du point de vue de l'encombrement ou de la maintenance.

Un premier agencement consiste à intercaler la carte de protection anti-foudre entre la carte fond de panier et le connecteur. Cet agencement entraîne la création d'un espace intercalaire entre le connecteur et la carte fond de panier. Cet espace intercalaire contenant la carte de protection anti-foudre augmente de manière significative l'encombrement de l'équipement électronique. En outre, le remplacement de la carte de protection anti-foudre nécessite le démontage de toutes les cartes filles, puis de la carte fond de panier, afin de pouvoir enfin accéder à la carte de protection anti-foudre.

Un deuxième agencement consiste à intégrer une carte de protection anti-foudre sur chaque carte fille. La carte fille, de forme allongée, comporte une première partie comprenant les composants relatifs à la carte fille elle-même et une deuxième partie comprenant les composants relatifs à la carte de protection anti-foudre. Cet agencement entraîne également l'augmentation de l'encombrement de l'équipement électronique du fait de l'allongement de la carte fille. En outre, lorsqu'une carte de protection anti-foudre subit des avaries, il est nécessaire de remplacer toute la carte fille, ce qui représente un coût non négligeable.

### EXPOSE DE L'INVENTION

Un objet de la présente invention est de proposer un équipement électronique comportant un boîtier et au moins une carte électronique qui ne présente pas les inconvénients de l'art antérieur et qui en particulier permet une maintenance aisée.

A cet effet, est proposé un équipement électronique pour un système électronique, l'équipement électronique comportant :
- un boîtier,
- une carte fond de panier logée dans le boîtier,
- un connecteur fixé sur la carte fond de panier et configuré pour se raccorder au reste du système électronique,
- au moins une carte fille logée dans le boîtier, et
- pour chaque carte fille, une carte de protection anti-foudre logée dans le boîtier,
ledit équipement électronique étant caractérisé en ce que
- pour chaque carte de protection anti-foudre,
   - un premier port est arrangé pour connecter la carte de protection anti-foudre sur la carte fond de panier, et
   - un deuxième port est arrangé pour connecter la carte fille sur la carte de protection anti-foudre.

Un tel agencement permet un gain de coût et de temps lors de la maintenance et le remplacement de la carte de protection anti-foudre lorsque celle-ci a subi des avaries.

Avantageusement, le premier port et le deuxième port ont des directions d'emmanchement perpendiculaires.

Avantageusement, le deuxième port est du type à emmanchement perpendiculaire à la carte de protection anti-foudre.

Avantageusement, pour chaque paire d'une carte de protection anti-foudre et d'une carte fille, l'équipement électronique présente un boîtier indépendant dans lequel sont fixées la carte de protection et la carte fille.

L'invention propose également un aéronef comportant un système électronique présentant au moins un équipement électronique selon l'une des variantes précédentes.

### BREVE DESCRIPTION DES DESSINS

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
la Fig. 1 représente une vue de côté d'un aéronef comportant un équipement électronique selon l'invention,
la Fig. 2 est une vue de dessus en coupe d'un équipement électronique selon l'invention, et
la Fig. 3 est une vue éclatée en perspective d'une partie de l'équipement électronique selon l'invention.

### EXPOSE DETAILLE DE MODES DE REALISATION

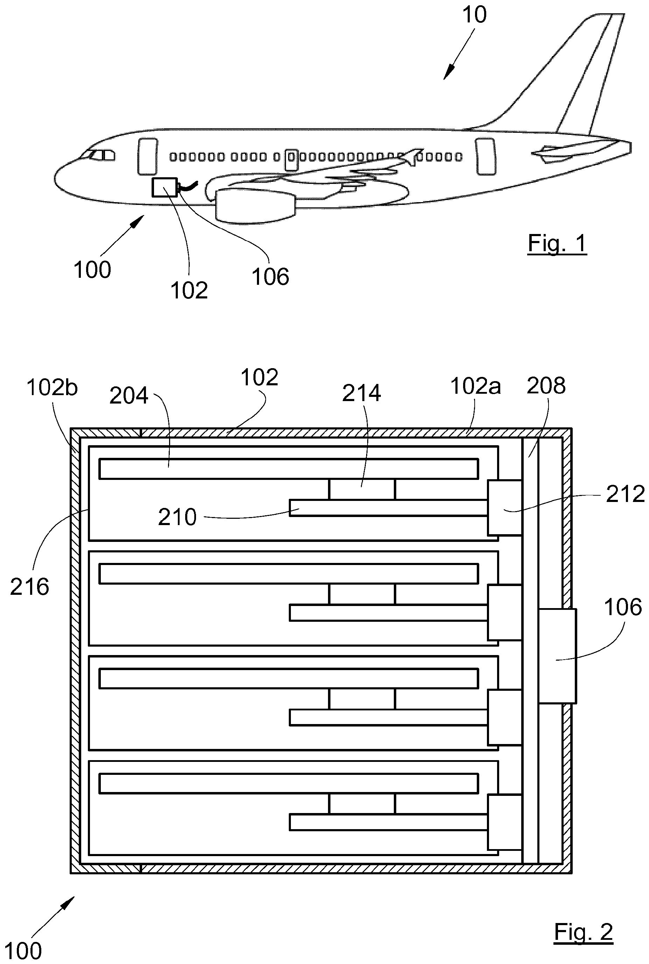

La Fig. 1 montre un aéronef 10 comportant un système électronique qui présente au moins un équipement électronique 100 présentant un boîtier 102 et au moins une carte électronique (204, Fig. 2), dite carte fille et logée dans le boîtier 102. L'équipement électronique 100 comporte un connecteur 106 qui permet de raccorder électriquement l'équipement électronique 100 au reste du système électronique de l'aéronef 10.

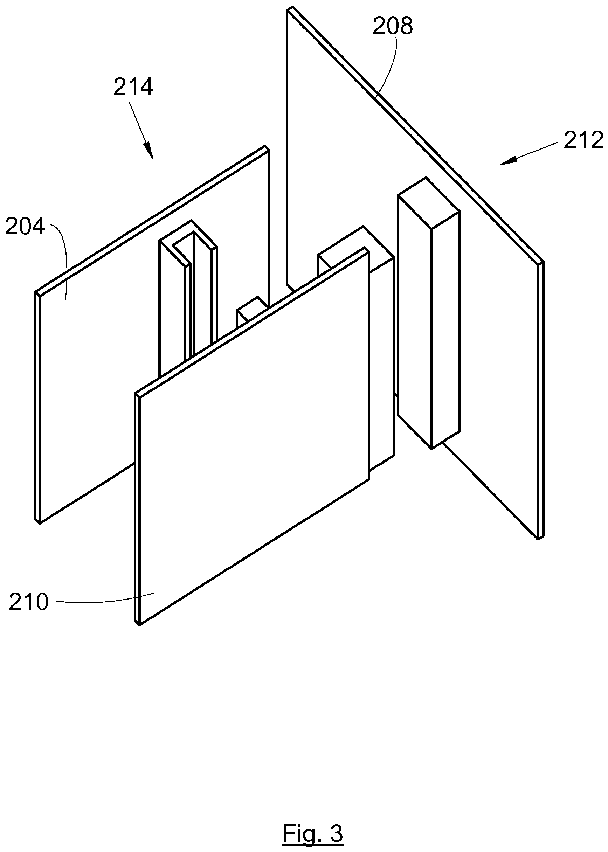

La Fig. 2 montre l'équipement électronique 100 en vue de dessus et coupé par un plan parallèle à la face supérieure du boîtier 102 et la Fig. 3 montre une partie de l'équipement électronique 100 en vue éclatée.

L'équipement électronique 100 comporte également une carte fond de panier 208 logée dans le boîtier 102 et sur laquelle le connecteur 106 est fixé.

L'équipement électronique 100 comporte également, pour chaque carte fille 204, une carte de protection 210 anti-foudre qui est également logée dans le boîtier 102.

L'équipement électronique 100 comporte également, pour chaque carte de protection 210 anti-foudre, un premier port 212 arrangé pour connecter de manière amovible la carte de protection 210 anti-foudre sur la carte fond de panier 208, et un deuxième port 214 arrangé pour connecter de manière amovible la carte fille 204 sur la carte de protection 210 anti-foudre. On dit que la connexion entre deux cartes est amovible, si la séparation des deux cartes s'effectue sans destruction de l'une ou l'autre des deux cartes.

Ainsi lorsqu'une carte de protection 210 anti-foudre doit être remplacée, il suffit de retirer la carte de protection 210 anti-foudre au niveau du premier port 212 et de la désolidariser au niveau du deuxième port 214 pour la séparer de la carte fille 204 et ainsi pouvoir la remplacer aisément.

Cet agencement permet de remplacer uniquement la carte de protection 210 anti-foudre abîmée sans remplacer la carte fille 204 associée. Cet agencement permet également un gain de temps puisqu'il n'est pas nécessaire de démonter la carte fond de panier 208. En outre, chaque carte de protection 210 anti-foudre peut être optimisée pour la carte fille 204 qui lui est associée.

Dans le mode de réalisation de l'invention présenté sur la Fig. 2, le boîtier 102 comporte une partie avant 102a qui porte le connecteur 106, la carte fond de panier 208, les cartes de protection 210 anti-foudre et les cartes filles 204, et une partie arrière 102b qui est fixée de manière amovible à la partie avant 102a et qui, lorsqu'elle est retirée, permet l'accès à l'intérieur du boîtier 102.

Pour un gain de place, le premier port 212 et le deuxième port 214 ont des directions d'emmanchement perpendiculaires.

Le premier port 212 est du type à emmanchement perpendiculaire à la carte fond de panier 208, c'est-à-dire que la carte de protection 210 anti-foudre se fixe sur la carte fond de panier 208 par déplacement le long d'une direction perpendiculaire à la surface de la carte fond de panier 208.

Le deuxième port 214 est du type à emmanchement perpendiculaire à la carte de protection 210 anti-foudre, c'est-à-dire que la carte fille 204 se fixe sur la carte de protection 210 anti-foudre par déplacement le long d'une direction perpendiculaire à la carte de protection 210 anti-foudre.

Chaque port 212, 214 permet la connexion de deux de cartes 208, 210, 204 d'une paire entre elles. Dans le mode de réalisation de l'invention présenté sur la Fig. 3, chaque port 212, 214 est constitué d'une partie solidaire d'une première carte de la paire et d'une deuxième partie solidaire de la deuxième carte de la paire. Pour chaque port 212, 214, une partie est un connecteur femelle et une autre partie est un connecteur mâle qui s'introduit dans le connecteur femelle.

Pour une manipulation plus aisée de la carte de protection 210 anti-foudre et de la carte fille 204, l'équipement électronique 100 présente pour chaque paire d'une carte de protection 210 anti-foudre et d'une carte fille 204, un boîtier indépendant 216 dans lequel sont fixées la carte de protection 210 anti-foudre et la carte fille 204. Pour assurer la connexion du premier port 212, le boîtier indépendant 216 présente une fenêtre qui laisse passer l'extrémité de la carte de protection 210 anti-foudre et la partie du premier port 212 attachée à la carte de protection 210 anti-foudre qui est prévue pour coopérer avec la partie du premier port 212 attachée à la carte fond de panier 208.

La fixation de la carte de protection 210 anti-foudre et de la carte fille 204 dans le boîtier indépendant 216 est assurée par exemple par mise en place d'entretoises et de vis.

## Revendications

1. Equipement électronique (100) pour un système électronique, l'équipement électronique (100) comportant :
- un boîtier (102),
- une carte fond de panier (208) logée dans le boîtier (102),
- un connecteur (106) fixé sur la carte fond de panier (208) et configuré pour se raccorder au reste du système électronique,
- au moins une carte fille (204) logée dans le boîtier (102), et
- pour chaque carte fille (204), une carte de protection (210) anti-foudre logée dans le boîtier (102),
ledit équipement électronique (100) étant **caractérisé en ce que**
- pour chaque carte de protection anti-foudre (210),
- un premier port (212) est arrangé pour connecter la carte de protection anti-foudre (210) sur la carte fond de panier (208), et
- un deuxième port (214) est arrangé pour connecter la carte fille (204) sur la carte de protection anti-foudre (210).

2. Equipement électronique (100) selon la revendication 1, **caractérisé en ce que** le premier port (212) et le deuxième port (214) ont des directions d'emmanchement perpendiculaires.

3. Equipement électronique (100) selon la revendication 2, **caractérisé en ce que** le deuxième port (214) est du type à emmanchement perpendiculaire à la carte de protection anti-foudre (210).

4. Equipement électronique (100) selon l'une des revendications 1 à 3, **caractérisé en ce qu'**il présente pour chaque paire d'une carte de protection anti-foudre (210) et d'une carte fille (204), un boîtier indépendant (216) dans lequel sont fixées la carte de protection anti-foudre (210) et la carte fille (204).

5. Aéronef (10) comportant un système électronique présentant au moins un équipement électronique (100) selon l'une des revendications 1 à 4.

## Patentansprüche

1. Elektronische Ausrüstung (100) für ein elektronisches System, wobei die'arriéré elektronische Ausrüstung (100) Folgendes umfasst:
- ein Gehäuse (102),
- eine Rückwandplatte (208), die in dem Gehäuse (102) aufgenommen ist,
- einen Steckverbinder (106), der auf der Rückwandplatte (208) befestigt und konfiguriert ist, um sich an den Rest des elektronischen Systems anzuschließen,
- mindestens eine Tochterkarte (204), die in dem Gehäuse (102) aufgenommen ist, und
- für jede Tochterkarte (204) eine Blitzschutzkarte (210), die in dem Gehäuse (102) aufgenommen ist, elektronische Ausrüstung (100) **dadurch gekennzeichnet, dass**
- für jede Blitzschutzkarte (210)
- ein erster Port (212) eingerichtet ist, um die Blitzschutzkarte (210) an die Rückwandplatte (208) anzuschließen, und
- ein zweiter Port (214) eingerichtet ist, um die Tochterkarte (204) an die Blitzschutzkarte (210) anzuschließen.

2. Elektronische Ausrüstung (100) nach Anspruch 1, **dadurch gekennzeichnet, dass** der erste Port (212) und der zweite Port (214) senkrechte Ansteckrichtungen haben.

3. Elektronische Ausrüstung (100) nach Anspruch 2, **dadurch gekennzeichnet, dass** der zweite Port (214) vom Typ mit Anstecken senkrecht zu der Blitzschutzkarte (210) ist.

4. Elektronische Ausrüstung (100) nach einem der Ansprüche 1 bis 3, **dadurch gekennzeichnet, dass** sie für jedes Paar aus einer Blitzschutzkarte (210) und einer Tochterkarte (204) ein unabhängiges Gehäuse (216) aufweist, in dem die Blitzschutzkarte (210) und die Tochterkarte (204) befestigt sind.

5. Luftfahrzeug (10), das ein elektronisches System umfasst, das mindestens eine elektronische Ausrüstung (100) nach einem der Ansprüche 1 bis 4 aufweist.

## Claims

1. Electronic equipment item (100) for an electronic system, the electronic equipment item (100) comprising:
- a housing (102),
- a backplane board (208) housed in the housing (102),
- a connector (106) fixed to the backplane board (208) and configured to be connected to the rest of the electronic system,
- at least one daughterboard (204) housed in the housing (102), and
- for each daughterboard (204), a lightning protection board (210) housed in the housing (102),
said electronic equipment item (100) being **characterized in that**
- for each lightning protection board (210),
- a first port (212) is arranged to connect the lightning protection board (210) to the backplane board (208), and
- a second port (214) is arranged to connect the daughterboard (204) to the lightning protection board (210).

2. Electronic equipment item (100) according to Claim 1, **characterized in that** the first port (212) and the second port (214) have perpendicular directions of fitting.

3. Electronic equipment item (100) according to Claim 2, **characterized in that** the second port (214) is of the type with fitting perpendicular to the lightning protection board (210).

4. Electronic equipment item (100) according to one of Claims 1 to 3, **characterized in that** it has, for each pair of a lightning protection board (210) and a daughterboard (204), an independent housing (216) in which the lightning protection board (210) and the daughterboard (204) are fixed.

5. Aircraft (10) comprising an electronic system having at least one electronic equipment item (100) according to one of Claims 1 to 4.
